(19) Europäisches Patentamt
European Patent Office
Office européen des brevets

(11) Publication number: **0 190 251 B1**

(12) **EUROPEAN PATENT SPECIFICATION**

(45) Date of publication of patent specification: **30.01.91**

(51) Int. Cl.[5]: **H 01 J 37/256**

(21) Application number: **85903885.3**

(22) Date of filing: **02.08.85**

(86) International application number: **PCT/GB85/00344**

(87) International publication number: **WO 86/01335 27.02.86 Gazette 86/05**

# (54) METHOD AND APPARATUS FOR THE MICRO-ANALYSIS OR IMAGING OF SAMPLES.

(30) Priority: **02.08.84 GB 8419768**

(43) Date of publication of application: **13.08.86 Bulletin 86/33**

(45) Publication of the grant of the patent: **30.01.91 Bulletin 91/05**

(84) Designated Contracting States: **DE FR GB IT NL**

(56) References cited:
**FR-A-2 212 044**
**US-A-3 415 985**
**US-A-3 767 925**
**US-A-4 283 631**

**Journal of Vacuum Science and Technology,vol.15,no.3,May/June 1978,G.H.N.Riddle:"Electrostatic einzel lenses with reduced spherical aberration for use in field-emission guns",pages 857-868**

(73) Proprietor: **UNIVERSITY OF MANCHESTER INSTITUTE OF SCIENCE AND TECHNOLOGY**
**PO Box 88 Sackville Street**
**Manchester M60 1QD (GB)**

(72) Inventor: **ECCLES, Adrian, John**
**32 Allcroft Road Reading**
**Berkshire RG1 5HH (GB)**
Inventor: **BROWN, Alan**
**6 Swallow Close Macclesfield**
**Cheshire SK10 1QN (GB)**
Inventor: **VICKERMAN, John, Charles**
**4 Clothorn Road Didsbury**
**Manchester M20 0BQ (GB)**
Inventor: **VAN DEN BERG, Jakob, Albert**
**129 Atwood Road Didsbury**
**Manchester M20 0JW (GB)**

(74) Representative: **Atkinson, Peter Birch et al**
**Marks & Clerk Suite 301 Sunlight House Quay Street**
**Manchester M3 3JY (GB)**

Note: Within nine months from the publication of the mention of the grant of the European patent, any person may give notice to the European Patent Office of opposition to the European patent granted. Notice of opposition shall be filed in a written reasoned statement. It shall not be deemed to have been filed until the opposition fee has been paid. (Art. 99(1) European patent convention).

Courier Press, Leamington Spa, England.

EP 0 190 251 B1

## Description

The present invention relates to a method and apparatus for the micro-analysis or imaging of a sample by subjecting the sample to a particle beam and detecting secondary particles emitted from the sample.

Techniques of this type are known and lead to the generation of ions and electrons as secondary particles. Either of these particles may be detected. In the case of ion detection, a mass-spectrometric analysis of the particles may be performed. Electrons may be detected directly and used to provide an image of the sample under investigation.

The use of fine focussed ion beams for high resolution (0.1—10 μm) secondary electron (SEM) and secondary ion (SIMS) imaging and micro-analysis is now developing at a rapid pace and problems in e.g. integrated circuits, fracture surfaces, catalyst and polymer surfaces have been investigated.

The development of SIMS techniques exploiting the emission of *s*econdary *i*ons under particle bombardment for the *m*ass *s*pectrometric analysis of surfaces and bulk materials has followed different pathways since its birth about 25 years ago.

Historically, *Dynamic SIMS* in which the material is eroded under the impact of a high intensity primary beam at a comparatively high rate preceded *static SIMS* which uses a very low primary particle flux resulting in a near-preservation of the material surface during analysis.

In dynamic SIMS the object of the analysis is either to obtain spatial distributions (chemical maps) or depth distribution of chemical species (atoms, molecules) or both. Broadly speaking two approaches have been followed to realise this, termed the ion *microscope* (IMS) and the ion *microprobe* (IMP).

In the IMS the target is bombarded with an ion beam which may be broad and the secondary ions are transported and imaged directly onto a detector using ion optics and these determine the obtainable resolution (about 1 μm). During transport the spatial relationship of the ions with respect to their origin in the surface is maintained and by tuning the mass spectrometer, which forms part of the ion optics, to a particular mass a chemical map is obtained.

In the IMP a microfocussed ion beam is raster-scanned across the target whilst the signal of the emitted ions after mass analysis is fed to a synchronised TV screen. The resolution is in this case primarily determined by the ion probe diameter.

In all instrumental approaches mentioned, problems arise when dealing with insulating targets. Due to the impact of the ion beam they charge up and this results in signal instability, irreproducibility and sometimes complete loss of signal.

In the case of surfaces with position dependant (or varying) conductivity the setting-up procedure can be difficult. In addition, surface changes (e.g. decomposition or desorption) may be introduced by the ion beam.

To overcome the charging problem the application of a wide-diameter neutral bombarding beam in the ion microscope was patented by Castaing and Slodzian in 1968 (U.S. Patent No. 3 415 985) after earlier publications by Devienne and Roustan (Organic Mass Spectrom. *17* (1982) 173—81) on the use of neutral beams in a similar context.

Following these early developments which received only limited circulation, the use of neutral beams appears to have been 'forgotten' and was revived in the late seventies for the use in *Statis SIMA* and *organic mass spectroscopy.* It was termed FAB (fast atom bombardment) and uses large diameter (>1 mm) beams. The technique has been highly successful in the analysis of a wide range of insulating materials and surfaces, all the more so since it has demonstrated the existence of a charge induced damage mechanism in some insulators.

Although the difficulties associated with the use of ion beams in SIMS analysis of insulations have been widely recognized, most if not all efforts have been directed at devising methods to cope with or to minimise the charge build-up problem except for those situations in which readily available non-focussed neutral beams could be applied: H. W. Werner and N. Warmoltz; J. Vac. Sci. Technol. *12(2)* (1984) 726 (esp. Table 2 therein); K. Wittmaack; J. Appl. Phys. *50(1)* (1979) 493; and C. P. Hunt, C. T. H. Stoddart and M. P. Seah; Surf Interface Anal. *3(4)* (1981) 157.

US—A—3 767 925 (Foley) discloses an apparatus and method for determining the spatial distribution of constituents and contaminants in a solid. The surface of the solid is scanned with a focussed ion or neutral particle beam to sputter excited particles from the surface of the solid, resulting in photon emissions which are characteristic particles and which are detected using a suitable detector. It may be deduced from the Patent and a subsequent paper in Science (11th August 1972, Page 481 *et seq*) that the Foley beam diameter at the target is 2—3 mm.

FR—A—2 212 044 describes an analysis technique in which a sample is bombarded with a neutral, non-scanning beam which has a diameter of the same order as that described in US—A—3 767 925.

According to a first aspect of the present invention there is provided an apparatus for the micro-analysis or imaging of a sample comprising:

(a) an arrangement for producing a scanning micro-focussed neutral atom beam said arrangement comprising:

(i) means for generating an ion beam;

(ii) means for scanning the ion beam;

(iii) means for focussing the ion beam to a point at which the sample will be located; and

(iv) charge exchange means between the focussing means and the sample position whereby a scanning neutral beam focussed on the sample is produced; and

(b) detection means for detecting secondary electrons or secondary ions emitted from the sample.

According to a second aspect of the present invention there is provided a method for the micro-analysis of a sample comprising:

(a) scanning the sample with a micro-focussed neutral atom beam, said beam being produced by the steps of:

(i) generating an atom beam;
(ii) scanning the atom beam;
(iii) focussing the ion beam to a point on the sample, and, before the point of focus of the ion beam;
(iv) subjecting the ion beam to a charge exchange operation to produce a scanning neutral beam which is focussed on the sample; and

(b) detecting secondary electrons or secondary ions emitted from the sample.

The detector for the secondary particles may be one which performs an analysis of the secondary ions or one which allows an image to be produced from secondary electrons.

In the case where secondary ions are detected, the method and apparatus of the invention may be used for various mass spectrometric micro-analysis techniques, including secondary ion imaging and depth profiling. In the case where electrons are detected, the technique may be used for secondary electron imaging.

The use of the primary scanning micro-focussed atom beam is particularly effective using the above-described analysis techniques when investigating insulating samples.

In use of the method, the target to be examined will be positioned at the focal point of the beam and the imaging or micro-analysis of the secondary particles obtained by conventional techniques ued in SIMS, FABMS or Imaging SIMS.

The invention will be further described by way of example only with reference to the accompanying drawings, in which:

Fig. 1 schematically illustrates one embodiment of the method of the invention;

Fig. 2 shows the secondary electron image obtained, using the method of the invention, for the glass beads on an insulating backing; and

Fig. 3 shows the results obtained for the glass beads using an ion beam.

As shown in the drawing, the method comprises the following steps:

a) production of ions from an ion source 1;

b) production of an ion beam from the source 1 by means of an extraction and focussing device 2;

c) removal of unwanted mass components from the beam by a mass analyser 3;

d) scanning of the ion beam by a scanner 4;

e) final focussing of the beam in an ion optical lens 5;

f) producing a neutral beam from the ion beam by a charge-exchange cell 6;

g) deflecting the remaining ions from the beam, with ion beam deflector 7;

h) scanning the focussed beam across the target 8; and

i) detecting particles emitted from target 8 with a detector 9.

The preferred method of performing each of the operations (a)—(i) will now be described.

(a) Ion source

This should be capable of producing a high quality beam of sufficient intensity to allow focussing. A source producing inert gas ions (e.g. $Ar^+$) is most commonly used but this is not essential. Typical requirements for the source would be a capability to deliver ion currents in the range 10—100 μA, a brightness of 100 $A/cm^2sr$, an energy spread $\leq 10$ eV (energy up to 10 kV). Suitable sources would be a duoplasmatron or an oscillating electron source. The latter type is preferred because of its simpler construction and lower operating pressure. In either case, hot (filament type) or cold cathodes may be used. The source may also be a liquid metal ion source.

(b) Extraction and focussing

The extraction serves to accelerate the ions from energies of a few eVs up to 10—20 keV and the focussing device is an electrostatic lens serving to produce the focussed beam. The extraction and focussing device 2 should be capable of focussing a sufficiently high part of the extracted beam current through a small aperture (e.g. 1—2 mm diameter placed 400—800 mm downstream of the beam). Typical values would be up to 5 μA depending on how much on-target current would be required. Typical systems would be an extractor cup and einzellens arrangements requiring 3—4 lens elements or a 2-element immersion lens.

(c) Mass analysis

It is highly preferred to incorporate a mass analyser 3 to remove unwanted components from the ion beam. Magnetic sector or a crossed magnetic-electric field (Wien filter) analysers are suitable. For example, a Wien filter of relatively low mass resolution, $M/\Delta M \approx 10$ for a 10 keV $Ar^+$ ion beam and with permanent magnets is suitable. The advantage of the Wien filter is that it allows the beam to go straight through.

(d) Scanning

Scanning must take place before charge exchange (for producing the neutral beam) as it is not possible to scan a neutral beam using electrostatic or magnetic means. X- and Y-deflection plates are suitable. A quadrupole rod arrangement is preferred as it allows X and Y deflection to occur at the same point downstream. The aperture referred to under the heading "Extraction and Focussing" above is placed immediately before this section. It is essential that before the scanning section, a small pre-deflection (1—5°) of the ion beam takes place to filter out energetic neutral material in the beam.

It should be noted that the components discussed under headings (a)—(d) above are commercially available in combination, e.g. as the Telefocus (trade mark) ion gun marketed by Atomika-Munich which is used for producing a scanned microfocussed ion beam.

(e) Final focussing

The requirement for the final focussing stage is that the focussing lens has a sufficiently long focal length to focus the beam to a point beyond the charge exchange cell discussed under heading (f) below so that a focussed neutral beam may be produced.

The preferred lens is an electrostatic asymmetric einzel-lens ((or unipotential lens) operated to focus the ion beam towards a point beyond the lens. Such lenses normally operated at short focal lengths using high central element voltages Vg and lens strengths $Vg/Vo \geqslant .7$ (where Vo is the potential of the electron source and both Vg and Vo are measured with respect to the potential of the outer electrode). In order to increase the focal length of the lens it is preferred to operate with a Vg/Vo value in the region of 0.5.

Additionally the focussing region of the lens should be at or adjacent to the point at which the ion beam exits from the lens to ensure that the focal point is as far as possible from the lens.

Further points which need to be considered are that the area around the beam bounded by the entrance aperture of the lens relative to the narrowest opening of the lens (i.e. the so-called 'fill factor') is relatively small. Fill factors of well below 0.33 are preferred and associated with this is the requirement that the spherical and chromatic aberration produced by the lens shoould be as low as possible.

A preferred lens for use in the invention is of the structure of that shown as lens 11 at page 857 of J. Vac. Sci. Technol 15(3) May/June 1978. This lens, operated with a Vg/Vo value of 0.5, gave a focal length of 60 mm on a computer simulation with a resultant theoretical spot size of well under 5 µm for an ion beam current of $10^{-9}$A.

(f) and (g) Charge exchange and ion beam deflection

After leaving the final focussing lens 5 the ion beam passes through a small chamber with a high (say $10^{-5}$ mbar) Ar gas pressure. Charge exchange reactions take place due to electron transfer between the gas atoms and energetic ions producing energetic neutral atoms. The efficiency of this process can be up to 20% depending on the gas pressure. The residual ions are deflected out of the beam just before it leaves the charge exchange cell. The production of neutral beams in this way is a well established experimental technique.

The focussed atom beam produced by the above steps is then scanned across the target and particles emitted from the target are detected and analysed by means conventionally used in SIMS, FABMS and imaging techniques. The analysis may for example, be secondary electron imaging.

Fig. 2 shows the secondary electron image (100×) of glass beads (highly insulating target) which has been subjected to a scanning microfocussed atom beam. Using ion beams such an image cannot be obtained (Fig. 3).

**Claims**

1. Apparatus for the micro-analysis or imaging of a sample comprising

(a) an arrangement for producing a scanning micro-focussed neutral atom beam said arrangement comprising:

(i) means for generating an ion beam;
(ii) means for scanning the ion beam;
(iii) means for focussing the ion beam to a point at which the sample will be located; and
(iv) charge exchange means between the focussing means and the sample position whereby a scanning neutral beam focussed on the sample is produced; and

(b) detection means for detecting secondary electrons or secondary ions emitted from the sample.

2. Apparatus as claimed in Claim 1 wherein the focussing means is located between the scanning means and the charge exchange means.

3. Apparatus as claimed in Claim 1 or 2 wherein the focussing means is an electrostatic asymmetric unipotential lens.

4. Apparatus as claimed in Claim 3 wherein the unipotential lens is capable of operating with a value of Vg/Vo in the region of 0.5.

5. Apparatus as claimed in any one of Claims 1 to 4 wherein extraction and focussing means are provided between the means for generating the ion beam and the means for scanning the ion beam.

6. Apparatus as claimed in Claim 5 wherein mass analysis means are provided between the extraction and focussing means and the means for scanning the ion beam.

7. A method for the micro-analysis of a sample comprising:

(a) scanning the sample with a micro-focussed neutral atom beam, said beam being produced by the steps of:

(i) generating an ion beam;
(ii) scanning the ion beam;
(iii) focussing the ion beam to a point on the sample, and, before the point of focus of the ion beam;
(iv) subjecting the ion beam to a charge exchange operation to produce a scanning neutral beam which is focussed on the sample; and

(b) detecting secondary electrons or secondary ions emitted from the sample.

8. A method as claimed in Claim 7 wherein the focussing of the ion beam is effected between the scanning of the beam and the charge exchange operation.

9. A method as claimed in Claim 7 wherein the ion beam is focussed by means of an electrostatic asymmetric einzel-lens.

10. A method as claimed in Claim 9 wherein the einzel-lens is operated with a value of Vg/Vo in the region of 0.5.

11. A method as claimed in Claim 7 wherein the ion beam is subjected to an extraction and focussing operation before being scanned.

12. A method as claimed in Claim 11 wherein the ion beam is subjected to a mass analysis operation between the extraction and focussing operation and the scanning.

**Patentansprüche**

1. Vorrichtung für die Mikroanalyse oder Abbildung einer Probe, umfassend

(a) eine Anordnung zum Erzeugen eines mikrofokussierten, neutralen Atomstrahls zum Abtasten, wobei diese Anordnung umfaßt:

(i) eine Einrichtung zur Erzeugung eines Ionenstrahls;

(ii) eine Einrichtung zum Abtasten des Ionenstrahls;

(iii) eine Einrichtung zum Fokussieren des Ionenstrahls auf einen Punkt, an dem die Probe sich befinden wird; und

(iv) eine Ladungsaustauscheinrichtung zwischen der Fokussiereinrichtung und der Probenposition, wodurch ein auf die Probe fokussierter neutraler Strahl zum Abtasten erzeugt wird; und

(b) eine Erfassungseinrichtung zum Erfassen von von der Probe emittierten Sekundärelektronen or Sekundärionen.

2. Vorrichtung nach Anspruch 1, wobei die Fokussiereinrichtung zwischen der Abtasteinrichtung und der Ladungsaustauscheinrichtung angeordnet ist.

3. Vorrichtung nach Anspruch 1 oder 2, wobei die Fokussiereinrichtung eine elektrostatische, asymmetrische, unipotentiale Linse ist.

4. Vorrichtung nach Anspruch 3, wobei die unipotentiale Linse mit einem Wert von Vg/Vo ungefähr 0,5 betriebsfähig ist.

5. Vorrichtung nach einem der Ansprüche 1 bis 4, wobei eine Extraktions- und Fokussiereinrichtung zwischen der Einrichtung zur Erzeugung des Ionenstrahls und der Einrichtung zum Abtasten des Ionenstrahls vorhanden ist.

6. Vorrichtung nach Anspruch 5, wobei eine Masseanalyseeinrichtung zwischen der Extraktions- und Fokussiereinrichtung und der Einrichtung zum Abtasten des Ionenstrahls vorhanden ist.

7. Verfahren zur Mikroanalyse einer Probe, umfassend:

(a) ein Abtasten der Probe mit einem mikrofokussierten, neutralen Atomstrahl, wobei der Strahl folgendermaßen erzeugt wird:

(i) Erzeugen eines Ionenstrahls;

(ii) Abtasten des Ionenstrahls;

(iii) Fokussieren des Ionenstrahls auf einen Punkt auf der Probe; und, vor der Fokussierstelle des Ionenstrahls;

(iv) Unterziehen des Ionenstrahls einem Ladungsaustausch zur Erzeugung eines neutralen, auf die Probe fokussierten Abtaststrahls; und

(b) Erfassung von von der Probe emittierten Sekundärelektronen oder Sekundärionen.

8. Verfahren nach Anspruch 7, wobei das Fokussieren des Ionenstrahls zwischen dem Abtasten des Strahls und dem Ladungsaustausch ausgeführt wird.

9. Verfahren nach Anspruch 7, wobei der Ionenstrahl mit Hilfe einer elektrostatischen, asymmetrischen Einzellinse fokussiert wird.

10. Verfahren nach Anspruch 9, wobei die Einzellinse mit einem Wert von Vg/Vo ungefähr 0,5 betrieben wird.

11. Verfahren nach Anspruch 7, wobei der Ionenstrahl einer Extraktion und Fokussierung unterzogen wird, bevor er abgetastet wird.

12. Verfahren nach Anspruch 11, wobei der Ionenstrahl zwischen der Extraktion und Fokussierung und dem Abtasten einer Massenanalyse unterzogen wird.

**Revendications**

1. Appareil pour la micro-analyse ou le visionnement d'un échantillon comprenant

(a) un agencement servant à produire un faisceau atomique neutre micro-focalisé de balayage comprenant:

(i) un moyen servant à générer un faisceau d'ions;

(ii) un moyen servant à balayer le faisceau d'ions;

(iii) un moyen servant à focaliser le faisceau d'ions sur un point auquel l'échantillon sera situé; et

(iv) un moyen servant d'échange de charge entre le moyen de focalisation et la position de l'échantillon grâce auquel un faisceau neutre de balayage focalisé sur l'échantillon est produit; et

(b) un moyen de détection servant à détecter des électrons secondaires ou des ions secondaires émis à partir de l'échantillon.

2. Appareil selon la revendication 1 dans lequel le moyen de focalisation est situé entre le moyen de balayage et le moyen d'échange de charge.

3. Appareil selon la revendication 1 ou 2 dans lequel le moyen de focalisation est une lentille unipotentielle asymétrique électrostatique.

4. Appareil selon la revendication 3 dans lequel la lentille unipotentielle est capable de fonctionner avec une valeur de Vg/Vo d'environ 0,5.

5. Appareil selon l'une quelconque des revendications 1 à 4 dans lequel des moyens d'extraction et de focalisation sont prévus entre le moyen servant à générer le faisceau d'ions et le moyen servant à balayer le faisceau d'ions.

6. Appareil selon la revendication 5 dans lequel des moyens d'analyse de masse sont prévus entre les moyens d'extraction et de focalisation et le moyen servant à balayer le faisceau d'ions.

7. Méthode pour la micro-analyse d'un échantillon, comprenant les étapes suivantes:

(a) balayer l'échantillon avec un faisceau atomique neutre micro-focalisé, ledit faisceau étant produit par les étapes suivantes:
 (i) générer un faisceau d'ions;
 (ii) balayer le faisceau d'ions;
 (iii) focaliser le faisceau d'ions sur un point de l'échantillon, et, devant le point de focalisation du faisceau d'ions;
 (iv) soumettre le faisceau d'ions à une opération d'échange de charge pour produire un faisceau neutre de balayage qui est focalisé sur l'échantillon; et

(b) détecter des électrons secondaires ou des ions secondaires émis à partir de l'échantillon.

8. Méthode selon la revendication 7, dans laquelle la focalisation du faisceau d'ions est effectuée entre le balayage du faisceau et l'opération d'échange de charge.

9. Méthode selon la revendication 7, dans laquelle le faisceau d'ions est focalisé au moyen d'une lentille-einzel asymétrique électrostatique.

10. Méthode selon la revendication 9, dans laquelle la lentille-einzel fonctionne avec une valeur Vg/Vo d'environ 0,5.

11. Méthode selon la revendication 7, dans laquelle le faisceau d'ions est soumis à une opération d'extraction et de focalisation avant d'être balayé.

12. Méthode selon la revendication 11, dans laquelle le faisceau d'ions est soumis à une opération d'analyse de masse entre l'opération d'extraction et de focalisation et le balayage.

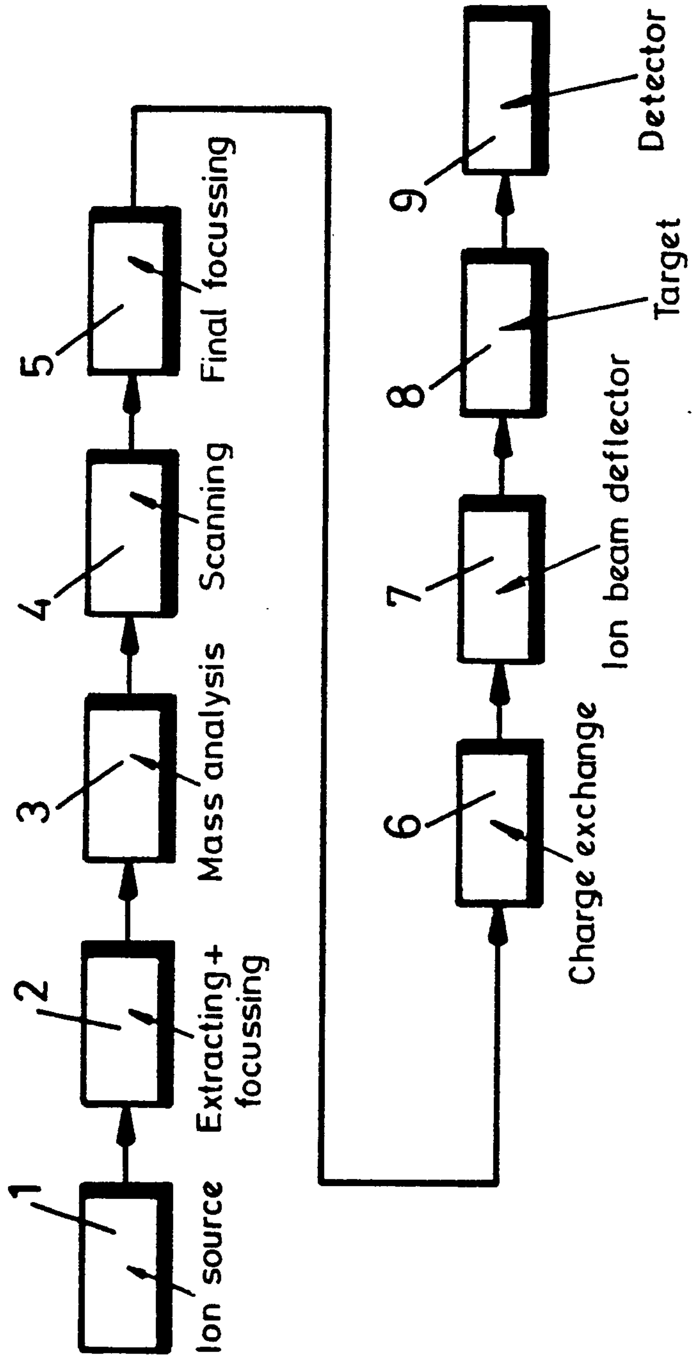
1
Ion source
2
Extracting + focussing
3
Mass analysis
4
Scanning
5
Final focussing
6
Charge exchange
7
Ion beam deflector
8
Target
9
Detector

FIG. 1

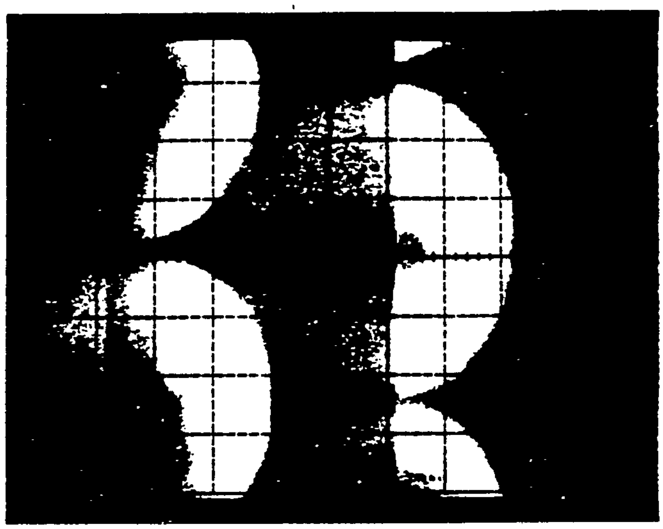

FIG. 2

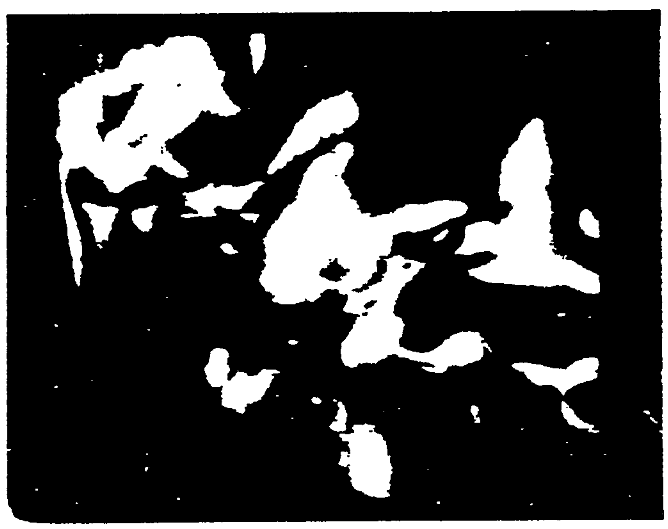

FIG. 3